# EUROPEAN PATENT SPECIFICATION

(11) **EP 3 786 245 B1**
(45) Date of publication and mention of the grant of the patent: **27.12.2023**
(21) Application number: 20192522.9
(22) Date of filing: 25.08.2020
(51) Int. Cl.: C09J 7/10, C09J 7/30, C08K 3/08

(54) **THERMOCONDUCTIVE ADHESIVE SHEET, PRODUCTION METHOD FOR THERMOCONDUCTIVE ADHESIVE SHEET, AND SEMICONDUCTOR DEVICE**
WÄRMELEITENDE KLEBEFOLIE, HERSTELLUNGSVERFAHREN FÜR WÄRMELEITENDE KLEBEFOLIE UND HALBLEITERBBAUELEMENT
FEUILLE ADHÉSIVE THERMOCONDUCTRICE, PROCÉDÉ DE PRODUCTION DE FEUILLE ADHÉSIVE THERMOCONDUCTRICE ET DISPOSITIF SEMICONDUCTEUR

(30) Priority: 26.08.2019 JP 2019153955; 28.02.2020 JP 2020033426
(43) Date of publication of application: 03.03.2021
(73) Proprietor: Kyocera Corporation, Kyoto-shi, Kyoto 6128501 (JP)
(72) Inventor: ARAKAWA, Yosuke, Kyoto 6128501 (JP); OKANO, Kazunori, Kyoto 6128501 (JP)
(74) Representative: Viering, Jentschura & Partner mbB Patent- und Rechtsanwälte

(56) References cited:
- JP-A- 2004 288 560
- JP-A- 2016 023 256
- US-A1- 2011 180 764
- US-A1- 2015 252 224
- US-B2- 7 422 707
- US-B2- 10 301 509

## Description

### Field of the Invention

The present disclosure relates to a thermoconductive adhesive sheet, production method for thermoconductive adhesive sheet, and a semiconductor device.

### Background of the Invention

Recently, with increase in the awareness of environmental issues, semiconductor devices for power generation have become widely used not only for general industrial applications and electric railroad applications but also for in-car applications. In particular, regarding in-car components, each component is desired to satisfy downsizing and weight-saving in a limited allowable size as directly linked to vehicle performance, and accordingly, for semiconductor devices for power generation for in-car components, downsizing is an extremely important issue. In such a semiconductor device, for example, a semiconductor element for power generation is mounted on a die pad on a DBC (direct bonded copper: registered trademark) substrate via a highly heat-resistant high-lead solder. However, use of lead-containing harmful substances has become controlled, and lead-free technology is desired.

As a highly heat-resistant lead-free bonding material except high-lead solder, a bonding method using a sintered silver paste is investigated, in which a nano-order silver filler is bonded at a temperature not higher than the melting point thereof (for example, see PTL 1). A sintered silver paste has a high thermal conductivity and is effective for bonding semiconductor elements for high-current power generation. However, from the viewpoint of downsizing and thinning semiconductor devices, a sheet material capable of forming a thin layer is desired for a bonding material.

A thermal conductivity of solder is generally 30 W/m·K, and therefore a sheet material having such a high thermal conductivity and capable of being a substitute for solder is desired, and such a sheet material has been proposed (for example, see PTL 2).

US 2011/180764 A1 discloses a powder containing silver nanoparticles having an average particle size of 2 to 50 nm in an amount of 95% or more by mass and applications of the powder. Silver-containing powder containing the silver nanoparticles is obtained by reducing a silver compound in the presence of a compound obtained by bonding polyethylene glycol to polyethyleneimine having a certain molecular weight and then by performing a concentration step and a drying step. A plastic substrate is obtained by directly applying a conductive paste that uses the powder on a plastic substrate and by performing drying.

US 2015/252224 A1 discloses a conductive composition containing a conductive metal powder and a resin component in which the conductive metal powder contains a metal flake and a metal nanoparticle and the resin component contains an aromatic amine skeleton.

### Citation List

### Patent Literature

PTL 1: WO2015/151136
PTL 2: JP 2016-536467 A

### Summary of the Invention

### Technical Problem

However, a few sheet materials having a high thermal conductivity are now on the market. This is because, when a sheet material is designed so as to express a thermal conductivity like that of a solder material, reliability characteristics thereof in a hot-cold cycle test may often worsen as a reaction thereto, and the sheet material described in PTL 2 still has room for improvement. Further, for expressing a high thermal conductivity, the particles contained in the sheet are sintered, and the sintering temperature needs to be 250°C or higher. However, in consideration of influence on organic substrates, oxidation of copper substrates and heat resistance of peripheral components, sintering at a further lower temperature (200°C or lower) is desired.

Well, a sheet material containing nano-size silver particles is excellent in low-temperature sintering performance but is problematic in temporary adhesiveness, and a sheet material containing micro-size silver particles is problematic in sheet performance. Further, for expressing thermal conductivity by the use of silver particles, the viscosity of the resin component needs to be low and the tackiness of the sheet material is problematic, but when the viscosity is lowered to such a degree that the tackiness of the sheet material is not problematic, then the temporary adhesiveness lowers.

The present disclosure has been made in consideration of the current condition, and is to provide a highly thermoconductive adhesive sheet excellent in temporary adhesiveness and sheet performance, having a high thermal conductivity even under low-temperature sintering conditions, and capable of giving a semiconductor device excellent in reliability. The present disclosure also provides a semiconductor device having a semiconductor element bonded thereto with the highly thermoconductive adhesive sheet.

### Solution to Problem

The present inventors have assiduously studied for the purpose of solving the above-mentioned problems and, as a result, have found that the following invention can solve the problems.

The present invention provides a thermoconductive adhesive sheet according to claim 1, a semiconductor device according to claim 12, and a production method for the thermoconductive adhesive sheet according to claim 13. Further embodiments of the present invention are disclosed in the dependent claims.

### Advantageous Effects of the Invention

According to the present disclosure, there can be provided a highly thermoconductive adhesive sheet excellent in temporary adhesiveness and sheet performance, having a high thermal conductivity even under low-temperature sintering conditions, and capable of giving a semiconductor device excellent in reliability. Also there can be provided a semiconductor device having a semiconductor element bonded thereto with the highly thermoconductive adhesive sheet.

### Brief Description of the Invention

The present disclosure is described in detail hereinunder with reference to embodiments thereof.

In the present disclosure, "(meth) acrylate" means acrylate and/or methacrylate.

### <Thermoconductive Adhesive Sheet>

The thermoconductive adhesive sheet of this embodiment is sheet-like formed of a resin composition containing (A) silver particles, (B) a thermosetting resin, and (C) a binder resin, wherein the silver particles (A) are secondary particles formed through aggregation of particles that contain primary particles having an average particle size of 10 to 100 nm.

### [(A) Silver Particles]

The silver particles (A) are secondary particles formed through aggregation of particles that contain primary particles having an average particle size of 10 to 100 nm. The silver particles (A) may be silver particles of secondary particles formed through aggregation of primary particles having the above-mentioned average particle size, or may also be silver particles of secondary particles formed through aggregation of particles that contain primary particles having the above-mentioned average particle size and particles having a larger average particle size than the above-mentioned average particle size.

When the average particle size of the primary particles is less than 10 nm, the specific surface area may be large and the sheet may be brittle; but when the average particle size is more than 100 nm, the sintering performance may worsen. From these viewpoints, the average particle size of the primary particles may be 10 to 50 nm, or may be 20 to 50 nm.

The average particle size of the primary particles can be measured as follows. Silver particles is embedded in epoxy resin under curing conditions of 60 ° C for 120 minutes. In addition, a flat milling is carried out at a focused ion beam (FIB) device, with a processing voltage of 4.0kV, a sloping angle of 80 °, and a processing time of 1.5 minutes. The cross section of the spherical silver particles obtained is observed with a field emission scanning electron microscope (FE-SEM) at an accelerated voltage of 1.0kV, a magnification 10,000-200,000 times. And the equivalent circle diameter of 200 silver particles is measured. The circle equivalent diameters of the measured 200 silver particles is image-processed using image analysis software, and the numbers is averaged. Specifically, the average particle size can be determined according to the method described in the section of Examples.

Further, the silver particles (A) may have a positive thermal expansion coefficient in a sintering temperature region between 150°C and 300°C. The thermal expansion coefficient of the silver particles (A) may be 0.2 to 10.0 ppm/°C, or may be 1.5 to 8.0 ppm/°C.

In the present disclosure, the thermal expansion coefficient of silver particles is measured as follows. Using a mini-hydraulic press (from Specac Corporation), a load of 200 kgf is given to powdery Ag particles for 1 minute to give columnar pellet sample having a diameter of 5 mm and a thickness of 1 mm, and using a thermomechanical analyzer (TMA) (trade name: TMA SS150, from Seiko Instruments Inc.), the resultant sample is heated from room temperature (25°C) up to 350°C at a temperature rise rate of 20°C/min to measure the thermal expansion thereof. Based on the pellet length at 25°C, the thermal expansion coefficient falling within a sintering temperature region between 150°C and 300°C is determined.

The sintering start temperature for silver particles having a positive linear expansion coefficient is a temperature at the timing of start of shrinkage, that is, at the time at which the thermal expansion coefficient has reached the maximum, and in general, the temperature range is between 150°C and 300°C.

When the temperature that shows the thermal expansion coefficient falls within the range, the opportunity for the contact of silver particles with each other increases owing to expansion of silver particles during sintering thereof in the thermoconductive adhesive sheet, and therefore the sinterability of the sheet can be bettered and the sheet can have a high thermal conductivity.

In particular, in a thermoconductive adhesive sheet containing a binder resin as an indispensable component, the proportion of a reactive functional group therein as a resin component is small, and therefore the volume exclusion effect accompanied by resin curing shrinkage is small, that is, the sintering accelerating effect owing to approximation of silver particles to each other during sintering of silver particles becomes small, and the degree of freedom of silver particles becomes also small, and as a result, the sheet containing silver particles having a positive thermal expansion coefficient can have a high thermal conductivity.

The average particle size of the silver particles (A) (secondary particles) is 0.5 to 5.0 pm, or may be 0.5 to 3.0 pm, or may be 1.0 to 3.0 pm. When the average particle size of the secondary particles is 0.5 µm or more, preservation stability betters, and when it is 5.0 pm or less, sinterability improves.

The average particle size of the secondary particles is a particle size to provide an integrated volume of 50% in a particle size distribution measured using a laser diffraction-type particle sizer (50% particle size D50), and specifically, it is measured according to the method described in the section of Examples.

The tap density of the silver particles (A) may be 4.0 to 7.0 g/cm³, or may be 4.5 to 7.0 g/cm³, or may be 4.5 to 6.5 g/cm³. When the tap density of the silver particles (A) is 4.0 g/cm³ or more, the silver particles can be highly filled in the resin composition, and when it is 7.0 g/cm³ or less, the silver particles can be prevented from precipitating during sheet formation.

The tap density of the silver particles (A) can be measured using a tap densitometer based on ASTM Standard Test Method B 527, and specifically, it can be measured according to the method described in the section of Examples.

The specific area of the silver particles (A), as measured according to a BET method, may be 0.5 to 1.5 m²/g, or may be 0.5 to 1.2 m²/g, or may be 0.6 to 1.2 m²/g. When the specific surface area is 0.5 m²/g or more, the sheet can be prevented from being sticky, and when it is 1.5 m²/g or less, temporary adhesiveness improves.

The specific surface area of the silver particles (A) can be measured according to a BET 1-point method by nitrogen adsorption, using a specific surface area meter, and specifically, it can be measured according to the method described in the section of Examples.

The silver particles (A) are secondary particles formed through aggregation of nano-size primary particles, and therefore maintain the high activity that the surface of the primary particle has, and have the ability to sinter the secondary particles with each other at low temperatures (self-sinterability). In addition, sintering of silver particles with each other and sintering of silver particles and the bonding component proceed simultaneously. Consequently, using the silver particles (A), it is possible to provide a thermoconductive adhesive sheet excellent in thermal conductivity and adhesion property.

The shape of the silver particles (A) is not specifically limited, and examples thereof include spheres, flakes and scales. The shape of the silver particles (A) may be spherical.

The silver particles (A) may also be hollow particles, or solid particles. Here, a hollow particle means a particle having a hollow space inside it. In the case where the silver particles (A) are hollow particles, the silver particle may have a hollow space in the center part thereof. A solid particle means a particle not substantially having a hollow space inside the particle.

### (Method for Producing Silver Particles (A))

A method for producing the silver particles (A) is not specifically limited. One example of the production method includes a step of adding an aqueous ammonia to an aqueous solution containing a silver compound to give a silver ammine complex solution, and a step of reducing the silver ammine complex in the silver ammine complex solution prepared in the previous step with a reducing compound to give a slurry containing silver particles.

### (Step of preparing silver ammine complex solution)

In this step, aqueous ammonia is added to an aqueous solution containing a silver compound to give a silver ammine complex solution.

The silver compound includes silver nitrate, silver chloride, silver acetate, silver oxalate and silver oxide. The silver compounds may be, from the viewpoint of solubility in water, silver nitrate or silver acetate.

The amount of ammonia to be added may be 2 to 50 mol per mol of silver in the silver compound-containing aqueous solution, or may be 5 to 50 mol, or may be 10 to 50 mol. When the amount of ammonia to be added falls within the range, the average particle size of the primary particles can be made to fall within the above-mentioned range.

The resultant silver ammine complex solution may contain a silver powder having an average particle size of 0.5 to 20 pm.

### (Step of preparing silver particle-containing slurry)

In this step, the silver ammine complex in the silver ammine complex solution prepared in the previous step is reduced with a reducing compound to give a silver particle-containing slurry.

By reducing the silver ammine complex with a reducing compound, the primary particles of silver particles in the silver ammine complex aggregate to form secondary particles each having a hollow space in the center thereof (hollow particles). In the case where a silver powder having an average particle size of 0.5 to 20 µm is contained in the silver ammine complex solution contains in the previous step, the primary particles of silver particles in the silver ammine complex aggregate around the silver powder to form secondary particles (solid particles).

By appropriately controlling the silver amount in the silver ammine complex and the content of the reducing compound, aggregation of the primary particles can be controlled, and the average particle size of the resultant secondary particles can be thereby controlled to fall within the above-mentioned range.

Not specifically limited, the reducing compound may be any compound having a reducing power of reducing the silver ammine complex to precipitate silver. Examples of the reducing compound include hydrazine derivatives.

Examples of the hydrazine compounds include hydrazine monohydrate, methylhydrazine, ethylhydrazine, n-propylhydrazine, i-propylhydrazine, n-butylhydrazine, i-butylhydrazine, sec-butylhydrazine, t-butylhydrazine, n-pentylhydrazine, i-pentylhydrazine, neo-pentylhydrazine, t-pentylhydrazine, n-hexylhydrazine, i-hexylhydrazine, n-heptylhydrazine, n-octylhydrazine, n-nonylhydrazine, n-decylhydrazine, n-undecylhydrazine, n-dodecylhydrazine, cyclohexylhydrazine, phenylhydrazine, 4-methylphenylhydrazine, benzylhydrazine, 2-phenylethylhydrazine, 2-hydrazinoethanol, and acetohydrazine. One alone or two or more kinds of these may be used either singly or as combined.

The content of the reducing compound may be 0.25 to 20.0 mol per mol of silver in the silver ammine complex, or may be 0.25 to 10.0 mol, or may be 1.0 to 5.0 mol. When the content of the reducing compound falls within the above range, the average particle size of the resultant secondary particles can be controlled to fall within the above-mentioned range.

The temperature of the silver ammine complex solution in reducing the silver ammine complex may be less that 30°C or 0 to 20°C. When the temperature of the silver ammine complex solution falls within the range, aggregation of the primary particles can be controlled, and the average particle size of the resultant secondary particles can be controlled to fall within the above-mentioned range.

### (Step of introducing protective group into silver particles)

The method for producing the silver particles (A) may include, after the step of preparing silver particle-containing slurry, a step of adding an organic protective compound to the silver particle-containing slurry prepared in the previous step to introduce a protective group into the silver particles.

Examples of the organic protective compound include a carboxylic acid, an amine and an amide. From the viewpoint of improving dispersibility, the organic protective compound may be a carboxylic acid.

Examples of the carboxylic acid include a monocarboxylic acid such as formic acid, acetic acid, propionic acid, butyric acid, valeric acid, hexanoic acid, caprylic acid, octylic acid, nonanoic acid, capric acid, oleic acid, stearic acid, and isostearic acid; a dicarboxylic acid such as oxalic acid, malonic acid, succinic acid, glutaric acid, adipic acid, pimellic acid, suberic acid, azelaic acid, sebacic acid, and diglycolic acid; an aromatic carboxylic acid such as benzoic acid, phthalic acid, isophthalic acid, terephthalic acid, salicylic acid and gallic acid; and hydroxy acid such as glycolic acid, lactic acid, tartronic acid, malic acid, glyceric acid, hydroxybutyric acid, tartaric acid, citric acid and isocitric acid.

The blending amount of the organic protective compound may be 1 to 20 mmol per mol of silver particles, or may be 1 to 10 mmol, or may be 1 to 5 mmol. When the blending amount of the organic protective compound is 1 mmol or more, silver particles can disperse in resin, and when the amount is 20 mmol or less, silver particles can disperse in resin while not detracting from the sinterability thereof.

The content of the silver particles (A) may be 30 to 95% by mass relative to the total amount of the resin composition, or may be 30 to 80% by mass, or may be 35 to 70% by mass. When the content of the silver particles (A) is 30% by mass or more, thermal conductivity can be improved, and when the content is 95% by mass or less, adhesion strength can be increased.

### [(B) Thermosetting Resin]

As the thermosetting resin (B), any thermosetting resin generally usable for adhesives can be used here with no specific limitation. The thermosetting resin may be liquid or may be a solid material having a softening point of 70°C or lower, or may be a liquid resin at room temperature (25°C). From the viewpoint of adhesion use, the thermosetting resin (B) may be at least one selected from the group consisting of an epoxy resin, an isocyanate resin and a maleimide resin, and may be an epoxy resin. One alone or two or more kinds of these may be used either singly or as combined.

The epoxy resin is a compound having one or more glycidyl groups in the molecule, and is a resin in which, when heated, the glycidyl group reacts to form a three-dimensional network structure to cure the resin. The epoxy resin may also be a compound containing 2 or more glycidyl groups in one molecule. This is because a compound having one glycidyl group could not exhibit sufficient cured product properties even when reacted by itself. A compound having 2 or more glycidyl groups in one molecule can be prepared by epoxidating a compound having 2 or more hydroxy groups. Though not limited thereto, such compounds include bisphenol compounds and derivatives thereof such as bisphenol A, bisphenol F, and biphenol; alicyclic structure-having diols and derivatives thereof such as hydrogenated bisphenol A, hydrogenated bisphenol F, hydrogenated biphenol, cyclohexanediol, cyclohexanedimethanol, and cyclohexanedimethanol; difunctional compounds prepared by epoxidating an aliphatic diol or a derivative thereof such as butanediol, hexanediol, octanediol, nonanediol, and decanediol; trifunctional compounds prepared by epoxidating a compound having a trihydroxyphenylmethane skeleton or an aminophenol skeleton; and polyfunctional compounds prepared by epoxidating a phenol-novolak resin, a cresol-novolak resin, a phenol-aralkyl resin, a biphenyl-aralkyl resin, or a naphthol-aralkyl resin.

The epoxy resin may be a liquid epoxy resin or a solid epoxy resin having a softening point of 70°C or lower, and may be a liquid epoxy resin. Here, the liquid epoxy resin is a liquid or semi-solid epoxy resin at room temperature (25°C), and is, for example, an epoxy resin having fluidity at room temperature (25°C). The viscosity of the liquid epoxy resin at 25°C may be 100,000 mPa·s or less, or may be 10,000 to 60,000 mPa s.

The viscosity of the liquid epoxy resin at 25°C can be measured with a rotary viscometer.

The weight-average molecular weight (Mw) of the liquid epoxy resin may be, from the viewpoint of fluidity and flexibility, 300 to 3,000, or may be 500 to 1,000. Here, in this description, Mw is a value determined by converting the chromatogram measured through gel permeation chromatography (GPC) into a standard polystyrene-equivalent molecular weight.

The liquid epoxy resin may be a biphenylaralkyl resin. The biphenylaralkyl resin is an epoxy resin having a biphenyl skeleton, and in this embodiment, the biphenyl skeleton may be hydrogenated in at least one aromatic ring of the biphenyl ring.

Examples of the biphenylaralkyl resin include 4,4'-bis(2,3-epoxypropoxy)biphenyl, 4,4'-bis(2,3-epoxypropoxy)-3,3',5,5'-tetramethylbiphenyl, 4,4'-(3,3',5,5'-tetramethyl)biphenyl, and an epoxy resin prepared by reacting epichlorohydrin and a bisphenol compound such as 4,4'-biphenol or 4,4'-(3,3',5,5'-tetramethyl)biphenol. The biphenylaralkyl resin may be a glycidyl ether of 4,4'-bis(2,3-epoxypropoxy)-3,3',5,5'-tetramethylbiphenyl, or a glycidyl ether of 4,4'-(3,3',5,5'-tetramethyl)biphenyl. One alone or two or more kinds of these biphenylaralkyl resins may be used either singly or as combined.

Examples of commercial products of the biphenylaralkyl resin include YX7105 from Mitsubishi Chemical Corporation. By using a liquid epoxy resin, especially a biphenylaralkyl resin, the melt viscosity of the resin composition can be readily controlled to fall within a preferred range even though highly filled with the silver particles (A), and further a thermoconductive adhesive sheet excellent in heat resistance can be obtained.

By combining the liquid epoxy resin and the silver particles (A), occurrence of cracking and peeling can be prevented, sheet performance is bettered, and suitable tackiness can be expressed at 50 to 80°C, and therefore temporary adhesiveness can be bettered. This is presumed to be because the surface area of the silver particles can keep the liquid component at room temerature and the resin component can soften at a temporary bonding temperature to express such good sheet performance.

Examples of the curing agent for epoxy resin include an aliphatic amine, an aromatic amine, a dicyandiamide, a dihydrazide compound, an acid anhydride and a phenolic resin. The aromatic amine includes diaminodiphenylmethane, m-phenylenediamine, diaminodiphenyl sulfone, diethyltoluenediamine, trimethylenebis(4-aminobenzoate), polytetramethylene oxide-di-p-aminobenzoate, and 4,4'-diamino-3,3'-diethyldiphenylmethane. The dihydrazide compound include a carboxylic acid dihydrazide such as adipic acid dihydrazide, dodecanoic acid dihydrazide, isophthalic acid dihydrazide, p-oxybenzoic acid dihydrazide. The acid anhydride includes phthalic anhydride, tetrahydrophthalic anhydride, hexahydrophthalic anhydride, endomethylene-tetrahydrophthalic anhydride, dodecenylsuccinic anhydride, a reaction product of maleic anhydride and polybutadiene, and a copolymer of maleic anhydride and styrene. The curing agent may be a curing agent containing a sulfone.

The content of the curing agent may be such that the ratio of the number (y) of the reactive functional groups that the curing agent has to the number (x) of the epoxy groups that the epoxy resin has, (y)/(x) falls within a range of 0.3 or more and 1.5 or less, or may fall within a range of 0.5 or more and 1.2 or less. When the ratio (y)/(x) is 0.3 or more, the reliability of the cured product can be improved, and when the ratio (y)/(x) is 1.5 or less, the strength of the cured product can be increased.

A curing accelerator may be blended in the resin composition for use in this embodiment for accelerating curing. The curing accelerator for epoxy resin includes imidazoles, triphenyl phosphine or tetraphenyl phosphine and salts thereof, amine compounds such as diazabicycloundecene, and salts thereof. The curing accelerator may be, for example, an imidazole compound such as 2-methylimidazole, 2-ethylimidazole, 2-phenylimidazole, 2-phenyl-4-methylimidazole, 2-phenyl-4-methyl-5-hydoxymethylimidazole, 2-phenyl-4,5-dihydroxymethylimidazole, 2-C₁₁H₂₃-imidazole, an adduct of 2-methylimidazole and 2,4-diamino-6-vinyltriazine, or may also be an imidazole compound having a melting point of 180°C or higher. From the viewpoint of bettering sinterability, the curing accelerator may be an active hydrogen-free imidazole such as 1-benzyl-2-phenylimidazole, 1-benzyl-2-methylimidazole or 1,2-dimethylimidazole.

The cyanate resin is a compound having an -NCO group in the molecule, in which the -NCO group reacts under heat to form a three-dimensional network structure, and the resin is thereby cured. Specifically, the cyanate resin includes 1,3-dicyanatobenzene, 1,4-dicyanatobenzene, 1,3,5-tricyanatobenzene, 1,3-dicyanatonaphthalene, 1,4-dicyanatonaphthalene, 1,6-dicyanatonaphthalene, 1,8-dicyanatonaphthalene, 2,6-dicyanatonaphthalene, 2,7-dicyanatonaphthalene, 1,3,6-tricyanatonaphthalane, 4,4'-dicyanatobiphenyl, bis(4-cyanatophenyl)methane, bis(3,5-dimethyl-4-cyanatophenyl)methane, 2,2-bis(4-cyanatophenyl)propane, 2,2-bis(3,5-dibromo-4-cyanatophenyl)propane, bis(4-cyanatophenyl) ether, bis(4-cyanatophenyl) thioether, bis(4-cyanatophenyl) sulfone, tris(4-cyanatophenyl) phosphite, tris(4-cyanatophenyl) phosphate, and cyanates produced by reacting a novolak resin and a cyanogen halide. A prepolymer having a triazine ring formed through trimerization of the cyanate group of these polyfunctional cyanate resins is also usable. The prepolymer can be produced by polymerizing the above-mentioned polyfunctional cyanate resin monomer using, for example, a catalyst of an acid such as a mineral acid or a Lewis acid, or a base such as a sodium alcoholate or a tertiary amine, or a salt such as sodium carbonate.

As the curing accelerator for the cyanate resin, any generally known one is usable. Examples thereof include an organic metal complex such as zinc octylate, tin octylate, cobalt naphthenate, zinc naphthenate, or iron acetylacetone; a metal salt such as aluminum chloride, tin chloride, or zinc chloride; and an amine such as triethylamine and dimethylbenzylamine, but these are not limitative. One alone or two or more kinds of these curing accelerators may be used either singly or as combined.

The maleimide resin is a compound having one maleimide group in one molecule, in which the maleimide group reacts under heat to form a three-dimensional network structure, and the resin is thereby cured. Examples of the maleimide resin include a bismaleimide resin such as N,N'-(4,4'-diphenylmethane)bismaleimide, bis(3-ethyl-5-methyl-4-maleimidephenyl)methane, and 2,2-bis[4-(4-maleimidephenoxy)phenyl]propane. The maleimide resin may be a compound obtained through reaction of a dimer acid diamine and a maleic anhydride; or a compound obtained through reaction of a maleimidated amino acid such as maleimide-acetic acid or maleimide-caproic acid and a polyol. The maleimidated amino acid is obtained through reaction of a maleic anhydride and an aminoacetic acid or an aminocaproic acid. The polyol may be a polyether polyol, a polyester polyol, a polycarbonate polyol, or a poly(meth)acrylate polyol, and may be one not containing an aromatic ring.

The content of the thermosetting resin (B) may be 1 to 30 parts by mass relative to 100 parts by mass of the silver particles (A), or may be 5 to 25 parts by mass. When the content of the thermosetting resin (B) is 1 part by mass or more, an adhesion effect by the thermosetting resin can be sufficiently secured, and when the content of the thermosetting resin (B) is 30 parts by mass or less, the proportion of the silver component can be prevented from lowering and therefore high thermal conductivity can be sufficiently secured and heat dissipation performance can be improved.

### [(C) Binder Resin]

The binder resin (C) is not specifically limited for use herein so far as it is a resin material for processing the resin composition into a sheet. The binder resin (C) includes a silicone oil, an acrylic resin, a phenoxy resin, a nitrile rubber, and an acrylic rubber. Above all, from the viewpoint of good sheet formability, an acrylic resin is preferred. One alone or two or more kinds of these may be used either singly or as combined.

The weight-average molecular weight (Mw)of the binder resin (C) may be 200,000 to 1,000,000, or may be 400,000 to 800,000. When the weight-average molecular weight of the binder resin (C) is 200,000 or more, sheet formability improves, and when it is 1,000,000 or less, the viscosity of the blend can be suitable for forming a coating film.

The glass transition temperature (Tg) of the binder resin (C), may be -40°C to 0°C, or may be -30°C to -5°C. When the glass transition temperature of the binder resin (C) is -40°C or higher, the sheet surface is not tacky and the handleability thereof improves, and when it is 0°C or lower, sheet formability improves.

The glass transition temperature can be measured according to JIS K7121:2012.

The content of the binder resin (C) may be 5 to 35 parts by mass relative to 100 parts by mass of the silver particles (A), or may be 10 to 30 parts by mass. When the content of the binder resin (C) is 5 parts by mass or more, a good sheet can be produced, and when it is 35 parts by mass or less, thermal conductivity can be prevented from lowering.

The total content of the content of the thermosetting resin (B) and the content of the binder resin (C) may be 5 to 30% by mass relative to the total amount of the resin composition, or may be 6 to 25% by mass, or may be 8 to 20% by mass. When the total content of the content of the thermosetting resin (B) and the content of the binder resin (C) is 5% by mass or more, adhesion strength can be increased, and when it is 30% by mass or less, high thermal conductivity can be maintained.

### [Diluent]

The resin composition for use in this embodiment may further contain a diluent from the viewpoint of processability. Examples of the diluent include methyl ethyl ketone, toluene, butyl carbitol, cellosolve acetate, ethyl cellosolve, butyl cellosolve, butyl cellosolve acetate, butyl carbitol acetate, diethylene glycol dimethyl ether, diacetone alcohol, cyclohexanone, N-methyl-2-pyrrolidone (NMP), dimethylformamide, N,N-dimethylacetamide (DMAc), γ-butyrolactone, 1,3-dimethyl-2-imidazolidinone, and 3,5-dimethyl-1-adamantanamine (DMA). One alone or two or more kinds of these may be used either singly or as combined.

In the case where the resin composition for use in this embodiment contains a diluent, the content thereof may be 3 to 30 parts by mass relative to 100 parts by mass of the silver particles (A), or may be 4 to 25 parts by mass, or may be 4 to 20 parts by mass. When the content of the diluent is 3 parts by mass or more, viscosity reduction is possible by dilution, and when it is 30 parts by mass or less, the solvent fraction remaining in the sheet may be small and void formation in curing the resin composition can be suppressed.

### (Other Components)

The resin composition for use in this embodiment may optionally contain, in addition to the above-mentioned components and within a range not detracting from the advantageous effects of this embodiment, a coupling agent; a defoaming agent; a surfactant; a colorant such as pigment and dye; various polymerization inhibitors; an antioxidant; an inorganic ion exchanger; and other various additives generally blended in the composition of this kind. One alone or two or more kinds of these additives may be used either singly or as combined.

The coupling agent includes a silane coupling agent such as epoxysilane, mercaptosilane, aminosilane, alkylsilane, ureidosilane, vinylsilane, and sulfide silane; a titanate coupling agent; an aluminum coupling agent; and an aluminum/zirconium coupling agent.

The colorant includes carbon black.

The inorganic ion exchanger includes hydrotalcite.

The elastic modulus of the cured product of the resin composition may be 3 GPa or less, or may be 2.8 GPa or less.

The glass transition temperature (Tg) of the cured product of the resin composition may be 0°C or lower, or may be -6°C or lower.

The thermal expansion coefficient of the cured product of the resin composition may be 50 ppm/°C or less at -50 to -40°C and 140°C to 150°C, or may be 48 ppm/°C or less.

The elastic modulus, the glass transition temperature and the thermal expansion coefficient can be measured according to the methods described in the section of Examples.

The thermal conductivity of the cured product produced by curing the resin composition at 200°C or lower may be 30 W/m·k or more, or may be 32 W/m·k or more.

The thermal conductivity can be measured according to the method described in the section of Examples.

The thermoconductive adhesive sheet of this embodiment is favorable for use that requires thermal conductivity, especially as an adhesive sheet material useful for semiconductor bonding application. In particular, the sheet can maintain good thermal conductivity even in heat generation from devices.

### <Production Method for Thermoconductive Adhesive Sheet>

One example of a production method for the thermoconductive adhesive sheet of this embodiment includes mixing (A) silver particles, (B) a thermosetting resin, and (C) a binder resin to give a resin composition, and forming the resin composition into a sheet.

The thermoconductive adhesive sheet of this embodiment may be formed on a supporting film.

The resin composition may be prepared by fully mixing (A) silver particles, (B) a thermosetting resin and (C) a binder resin, and other optional components, using a disperser, a kneader, a rotation-revolution mixer or the like.

As the components of (A) silver particles, (B) a thermosetting resin and (C) a binder resin, and other optional components, those described in the section of

### <Thermoconductive Adhesive Sheet> can be used.

Next, the resin composition is applied onto a supporting film and dried to form a sheet thereon. As the coating method, employable is any known method such as a gravure coating method, a die coating method, a comma coating method, a lip coating method, a cap coating method, or a screen printing method. The drying temperature may be 70°C to 120°C, or may be 80°C to 100°C. When the drying temperature is 70°C or higher, the solvent fraction to remain in the sheet can be small and void generation in curing the resin composition can be prevented, and when it is 120°C or lower, sheet formability is good and the composition is easy to handle. One example of the coating device is pcoater 350 from Yasui Seiki Inc.

As the supporting film, usable is a plastic film of polyethylene, polypropylene, polyester, polycarbonate, polyarylate, polyacrylonitrile or the like with a release layer formed on one surface thereof.

The thickness of the supporting film is, from the viewpoint of handleability, generally 10 to 50 pm, and may be 25 to 38 pm.

The thickness of the thermoconductive adhesive sheet may be 10 to 100 pm, or may be 10 to 50 pm. When the thickness of the thermoconductive adhesive sheet is 10 pm or more, the sheet handleability is stable, and when it is 100 pm or less, tackiness of the sheet owing to the remaining solvent therein can be reduced.

### <Semiconductor Device>

The semiconductor device of this embodiment has a supporting member, a cured product of the thermoconductive adhesive sheet provided on the supporting member, and a semiconductor element bonded onto the supporting member via the cured product of the thermoconductive adhesive sheet.

The semiconductor device of this embodiment can be produced, for example, by temporarily bonding to the bonding surface of a silicon chip under the condition of a temperature of 50 to 80°C and a pressure of 0.1 to 1 MPa for a heating and pressing time of 0.1 to 1 minute, then mounting on a supporting member such as a copper frame and heating, pressing and bonding thereto under the condition of a temperature of 80 to 200°C and a pressure of 0.1 to 5 MPa for a heating and pressing time of 0.1 to 1 minute, and further heating and curing at 150 to 200°C for 0.5 to 2 hours.

Examples of the supporting member include metal substrates such as copper frames, aluminum or iron plates; ceramic substrates; and glass epoxy substrates.

Examples of the semiconductor element include IC, LSI, diodes, thyristors and transistors.

### Examples

Next, the present disclosure is described concretely with reference to Examples, but the present disclosure is not whatsoever restricted by these Examples.

### (Production of Silver Particles)

### [Synthesis Example 1]

40 g of silver nitrate was dissolved in 10 L of ion-exchanged water to prepare an aqueous silver nitrate solution, and 203 mL of an aqueous ammonia having a concentration of 26% by mass was added thereto and stirred to give an aqueous solution of a silver ammine complex. The aqueous solution was made to have a liquid temperature of 10°C, and with stirring, 28 mL of an aqueous solution of 20 mass% hydrazine monohydrate was dropwise added thereto, taking 60 seconds, to precipitate silver particles, thereby giving a slurry containing silver particles. To the slurry, oleic acid was added in an amount of 1% by mass relative to the silver amount, and stirred for 10 minutes. The slurry was filtered, and the residue was washed with water and with methanol, and dried at 60°C in a vacuum atmosphere for 24 hours to give silver particles having an average particle size of primary particles of 20 nm, an average particle size of secondary particles of 1.1 pm, a maximum thermal expansion coefficient of +5.5 ppm/°C, a tap density of 5.4 g/cm³, and a specific surface area of 1.2 m²/g.

The cross section of the resultant silver particles was observed with a field emission scanning electron microscope (FE-SEM) (JSM-6700F from JEOL Corp.), and the silver particles were confirmed to be hollow particles having a hollow space at the center of each particle.

### [Synthesis Example 2]

40 g of silver nitrate was dissolved in 10 L of ion-exchanged water to prepare an aqueous silver nitrate solution, and 203 mL of an aqueous ammonia having a concentration of 26% by mass was added thereto and stirred to give an aqueous solution of a silver ammine complex. The aqueous solution was made to have a liquid temperature of 10°C, and with stirring, 18 mL of an aqueous solution of 20 mass% hydrazine monohydrate was dropwise added thereto, taking 60 seconds, to precipitate silver particles, thereby giving a slurry containing silver particles. To the slurry, oleic acid was added in an amount of 1% by mass relative to the silver amount, and stirred for 10 minutes. The slurry was filtered, and the residue was washed with water and with methanol, and dried at 60°C in a vacuum atmosphere for 24 hours to give silver particles having an average particle size of primary particles of 20 nm, an average particle size of secondary particles of 1.5 pm, a maximum thermal expansion coefficient of +7.0 ppm/°C, a tap density of 5.2 g/cm³, and a specific surface area of 1.1 m²/g.

### [Synthesis Example 3]

40 g of silver nitrate was dissolved in 10 L of ion-exchanged water to prepare an aqueous silver nitrate solution, and 203 mL of an aqueous ammonia having a concentration of 26% by mass was added thereto and stirred to give an aqueous solution of a silver ammine complex. The aqueous solution was made to have a liquid temperature of 10°C, and with stirring, 12 mL of an aqueous solution of 20 mass% hydrazine monohydrate was dropwise added thereto, taking 60 seconds, to precipitate silver particles, thereby giving a slurry containing silver particles. To the slurry, oleic acid was added in an amount of 1% by mass relative to the silver amount, and stirred for 10 minutes. The slurry was filtered, and the residue was washed with water and with methanol, and dried at 60°C in a vacuum atmosphere for 24 hours to give silver particles of having an average particle size of primary particles of 20 nm, an average particle size of secondary particles of 2.6 pm, a maximum thermal expansion coefficient of +7.4 ppm/°C, a tap density of 5.0 g/cm³, and a specific surface area of 1.0 m²/g.

### [Synthesis Example 4]

40 g of silver nitrate was dissolved in 10 L of ion-exchanged water to prepare an aqueous silver nitrate solution, and 203 mL of an aqueous ammonia having a concentration of 26% by mass was added thereto and stirred to give an aqueous solution of a silver ammine complex. 50 g of a silver powder (trade name: Ag-HWQ, 1.5 pm, from Fukuda Metal, Foil & Powder Co., Ltd.) was put into the aqueous solution to prepare an aqueous solution of a silver powder-dispersed silver ammine complex. This was made to have a liquid temperature of 10°C, and with stirring, 28 mL of an aqueous solution of 20 mass% hydrazine monohydrate was dropwise added thereto, taking 60 seconds, to precipitate silver on the surface of the silver powder, thereby giving a slurry containing silver particles. To the slurry, oleic acid was added in an amount of 1% by mass relative to the silver amount, and stirred for 10 minutes. The slurry was filtered, and the residue was washed with water and with methanol, and dried at 60°C in a vacuum atmosphere for 24 hours to give silver particles having an average particle size of primary particles of 20 nm, an average particle size of secondary particles of 1.9 pm, a maximum thermal expansion coefficient of +2.5 ppm/°C, a tap density of 5.7 g/cm³, and a specific surface area of 1.0 m²/g.

The cross section of the resultant silver particles was observed with a field emission scanning electron microscope (FE-SEM) (JSM-6700F from JEOL Corp.), and the silver particles were confirmed to be solid particles such that silver aggregated around the silver powder and substantially no hollow space existed inside each particle.

The silver particle produced in Synthesis Examples 1 to 4 were evaluated according to the following methods.

### [Average Particle Size of Primary Particles]

For measurement of the average particle size of primary particles, used were silver particles prepared by dropwise adding 2.8 mL of an aqueous solution of 20 mass% hydrazine monohydrate to 1020 mL of the aqueous solution of a silver ammine complex produced in each of Synthesis Examples taking 60 seconds, followed by processing the mixture to solid-liquid separation, washing the resultant solid with pure water, and drying it at 60°C for 24 hours in a vacuum atmosphere.

The average particle size of the primary particles was measured as follows. Silver particles were embedded in epoheat CLR (manufactured by Buehler Ltd.) under curing conditions of 60 ° C for 120 minutes. In addition, a flat milling was carried out at a focused ion beam (FIB) device (JEM-9310FIB, from JEOL Corp.), with a processing voltage of 4.0kV, a sloping angle of 80 °, and a processing time of 1.5 minutes. The cross section of the spherical silver particles obtained was observed with a field emission scanning electron microscope (FE-SEM) (JSM-6700F, from JEOL Corp.) at an accelerated voltage of 1.0kV, a magnification 10,000-200,000 times. And the equivalent circle diameter of 200 silver particles was measured. The circle equivalent diameters of the measured 200 silver particles were image-processed using image analysis software ImageJ (manufactured by National Institute of Health, NIH), and the numbers were averaged.

### [Average Particle Size of Secondary Particles]

The average particle size of secondary particles was derived from the particle size that provided an integrated volume of 50% (50% particle size D50) in a particle size distribution measured using a laser diffraction-type particle sizer (trade name: SALAD-7500nano, from Shimadzu Corporation).

### [Thermal Expansion Coefficient]

Using a mini-hydraulic press (from Specac Corporation), a load of 200 kgf was given to silver particles for 1 minute to give a columnar pellet sample having a diameter of 5 mm and a thickness of 1 mm. Then, using a thermomechanical analyzer (TMA) (trade name: TMA SS150, from Seiko Instruments Inc.), the resultant sample was heated from room temperature (25°C) up to 350°C at a temperature rise rate of 20°C/min to measure the thermal expansion thereof. Based on the pellet length at 25°C, the maximum thermal expansion coefficient falling within a sintering temperature region between 150°C and 300°C was determined.

### [Tap Density]

The tap density (TD) was measured as a mass per unit volume (g/cm³) of the silver particles in a container shaken with a tap densitometer (Tap-Pak Volumeter, from Thermo Scientific Corporation) based on ASTM Standard Test Method B 527.

### [Specific Surface Area]

The specific surface area was measured according to a BET 1-point method by nitrogen adsorption, using a specific surface area meter (Monosorb, from Quanta Chrome Corporation) after degassed at 60°C for 10 minutes.

### (Examples 1 to 7, Comparative Examples 1 to 6)

### (1) Preparation of Resin Composition

The components of the kind and the amount as shown in Table 1 were mixed at 25°C using a rotation-revolution mixer (Model: ARV-310, from Thinky Corporation) to prepare a resin composition.

In Table 1, the blank means no addition.

### (2) Formation of Thermoconductive Adhesive Sheet

Using pCoater 350 from Yasui Seiki Inc., the resin composition was applied onto one release surface of a release film (trade name: TN-200 from Toyobo Co., Ltd., thickness 25 pm) according to a gravure coating method to form thereon a thermoconductive adhesive sheet having a thickness of 20 pm. The drying condition was a temperature of 80°C and a speed of 1 m/min.

Details of the components described in Table 1 and used for preparing the resin composition are as follows.

### [(A) Silver Particles]

(A1): Silver particles obtained in Synthesis Example 1 (average particle size of primary particles: 20 nm, average particle size of secondary particles: 1.1 pm, maximum thermal expansion coefficient: +5.5 ppm/°C, tap density: 5.4 g/cm³, specific surface area: 1.2 m²/g)

(A2): Silver particles obtained in Synthesis Example 2 (average particle size of primary particles: 20 nm, average particle size of secondary particles: 1.5 pm, maximum thermal expansion coefficient: +7.0 ppm/°C, tap density: 5.2 g/cm³, specific surface area: 1.1 m²/g)

(A3): Silver particles obtained in Synthesis Example 3 (average particle size of primary particles: 20 nm, average particle size of secondary particles: 2.6 pm, maximum thermal expansion coefficient: +7.4 ppm/°C, tap density: 5.0 g/cm³, specific surface area: 1.0 m²/g)

(A4): Silver particles obtained in Synthesis Example 4 (average particle size of primary particles: 20 nm, average particle size of secondary particles: 1.9 pm, maximum thermal expansion coefficient: +2.5 ppm/°C, tap density: 5.7 g/cm³, specific surface area: 1.0 m²/g)

### [Silver Particles except Component (A)]

TC-505C (trade name from Tokuriki Honten Co., Ltd., average particle size: 1.93 pm, maximum thermal expansion coefficient: -0.1 ppm/°C, tap density: 6.25 g/cm³, specific surface area: 0.65 m²/g)
Ag-HWQ 1.5 pm (trade name from Fukuda Metal Foil & Powder Co., Ltd., average particle size: 1.8 pm, maximum thermal expansion coefficient: -0.6 ppm/°C, tap density: 3.23 g/cm³, specific surface area: 0.5 m²/g)
AgC-221PA 1.5 pm (trade name from Fukuda Metal Foil & Powder Co., Ltd., average particle size: 7.5 pm, maximum thermal expansion coefficient: -0.1 ppm/°C, tap density: 5.7 g/cm³, specific surface area: 0.3 m²/g)
DOWAAg nano powder-1 (trade name from DOWAElectronics Materials Co., Ltd., average particle size: 20 nm, maximum thermal expansion coefficient: -0.1 ppm/°C)

### [(B) Thermosetting Resin]

Epoxy resin (trade name, YX7105 from Mitsubishi Chemical Corporation, liquid (viscosity at 25°C: 45,000 mPa-s))
Epoxy resin (trade name, jER1001 from Mitsubishi Chemical Corporation, solid (softening point 65°C))
Epoxy resin (trade name, jER1009 from Mitsubishi Chemical Corporation, solid (softening point 140°C))

### [(C) Binder Resin]

Acrylic binder (trade name, Nissetsu from Nippon Carbide Industries Co., Inc., weight-average molecular weight 500,000, glass transition temperature -10°C)
Acrylic binder (trade name, Nissetsu from Nippon Carbide Industries Co., Inc., weight-average molecular weight 100,000, glass transition temperature 0°C)

### [Diluent]

Methyl ethyl ketone (from Sankyo Chemical Co., Ltd.)

### [Other Components]

Curing agent: diaminodiphenyl sulfone (trade name, 4,4-DAS from Mitsui Fine Chemicals, Inc.)
Curing accelerator: imidazole-based curing accelerator (trade name, Curesol 2P4MHZ-PW, from Shikoku Chemicals Corporation)

Under the measurement conditions mentioned below, the properties of the adhesive sheets produced in Examples 1 to 7 and Comparative Examples 1 to 6 in which a thermoconductive adhesive sheet was formed on one surface of a release film (hereinafter may be simply referred to as adhesive sheets) were measured and evaluated. The evaluation results are shown in Table 1.

### <Evaluation Items>

### (1) Sheet Performance

The adhesive sheet was folded at 180 degrees, visually observed and evaluated according to the following criteria.

A: The thermoconductive adhesive sheets of the folded adhesive sheet did not adhere together and the folded part did not crack.

C: The thermoconductive adhesive sheets of the folded adhesive sheet adhered together or the folded part cracked.

### (2) Temporary Bonding Performance

A silicon chip of 6 mm × 6 mm, and a chip with gold on the back, which had a gold deposition layer on the bonding surface thereof, were pressure-bonded to the thermoconductive adhesive sheet-side of the adhesive sheet under the condition at 65°C for 1 second and under a pressure of 1 MPa, and a bondable sample was evaluated as "A", and an unbondable sample was evaluated as "C".

### (3) Elastic Modulus

The thermoconductive adhesive sheet was cured at 200°C for 2 hours, and cut to give a sample of 55 cm in length × 1 cm in width × 20 pm in thickness, and using a dynamic mechanical analyzer (device name: DMA from Seiko Instruments, Inc.), the sample was heated from -50°C up to 300°C at a temperature rise rate of 10°C/min to measure the elastic modulus thereof at 25°C.

### (4) Glass Transition Temperature (Tg)

The thermoconductive adhesive sheet was cured at 200°C for 2 hours, and cut to give a sample of 55 cm in length × 1 cm in width × 20 pm in thickness. Using a dynamic mechanical analyzer (device name: DMA from Seiko Instruments, Inc.), the sample was heated from -50°C up to 300°C at a temperature rise rate of 10°C/min to measure the glass transition temperature thereof.

### (5) Thermal Expansion Coefficient

The thermoconductive adhesive sheet was cured at 200°C for 2 hours, and cut to give a sample of 3 cm in length × 0.5 cm in width × 20 pm in thickness. Using a thermo-mechanical analyzer (device name: TMA/SS from Seiko Instruments, Inc.), the sample was heated from -50°C up to 200°C at a temperature rise rate of 10°C/min, and the sample deformation amount between -50°C and -40°C and between 140°C and 150°C was measured as a thermal expansion coefficient.

### (6) Thermal Conductivity (200°C curing)

The thermoconductive adhesive sheet was cured at 200°C for 2 hours, and cut to give a sample of 1 cm in length × 1 cm in width × 20 pm in thickness. Using a thermal conductance meter (device name: TC7000 from Advance Riko, Inc.) and according to JIS R 1611:1997, the thermal conductivity of the sample was measured according to a laser flash method. A sample having a thermal conductivity of 30 W/m·K or more was evaluated as good.

### (7) Thermal Conductivity (300°C curing)

The thermoconductive adhesive sheet was cured at 300°C for 2 hours, and cut to give a sample of 1 cm in length × 1 cm in width × 20 pm in thickness. Using a thermal conductance meter (device name: TC7000 from Advance Riko, Inc.) and according to JIS R 1611:1997, the thermal conductivity of the sample was measured according to a laser flash method. A sample having a thermal conductivity of 150 W/m·K or more was evaluated as good.

### (8) Hot Adhesion Strength

A silicon chip of 6 mm × 6 mm, and a chip with gold on the back, which had a gold deposition layer on the bonding surface thereof, were temporarily bonded to the thermoconductive adhesive sheet-side of the adhesive sheet under the condition at 65°C for 1 second and under a pressure of 1 MPa, then the release film of the adhesive sheet was peeled, and the other surface opposite to the surface that had been temporarily-bonded with the gold-backed chip of the thermoconductive adhesive sheet was mounted on a solid copper frame, and pressure-bonded thereto under heat at 125°C for 5 seconds and under a pressure of 0.1 MPa, and further cured in an oven at 180°C for 1 hour to prepare a sample. Using a mount strength measuring device (device name: 2200 EVO-plus from Besi Corporation), the hot die shear strength at 260°C of the sample was measured.

### (9) Reliability Test (hot-cold cycle)

The sample prepared in (8) was heated from -55°C up to 150°C in a hot-cold cycle tester, and then cooled to -55°C. This operation is one cycle, and each sample was tested in 1000 cycles to determine the incidence rate of defects (peeling failure) (number of samples = 20).

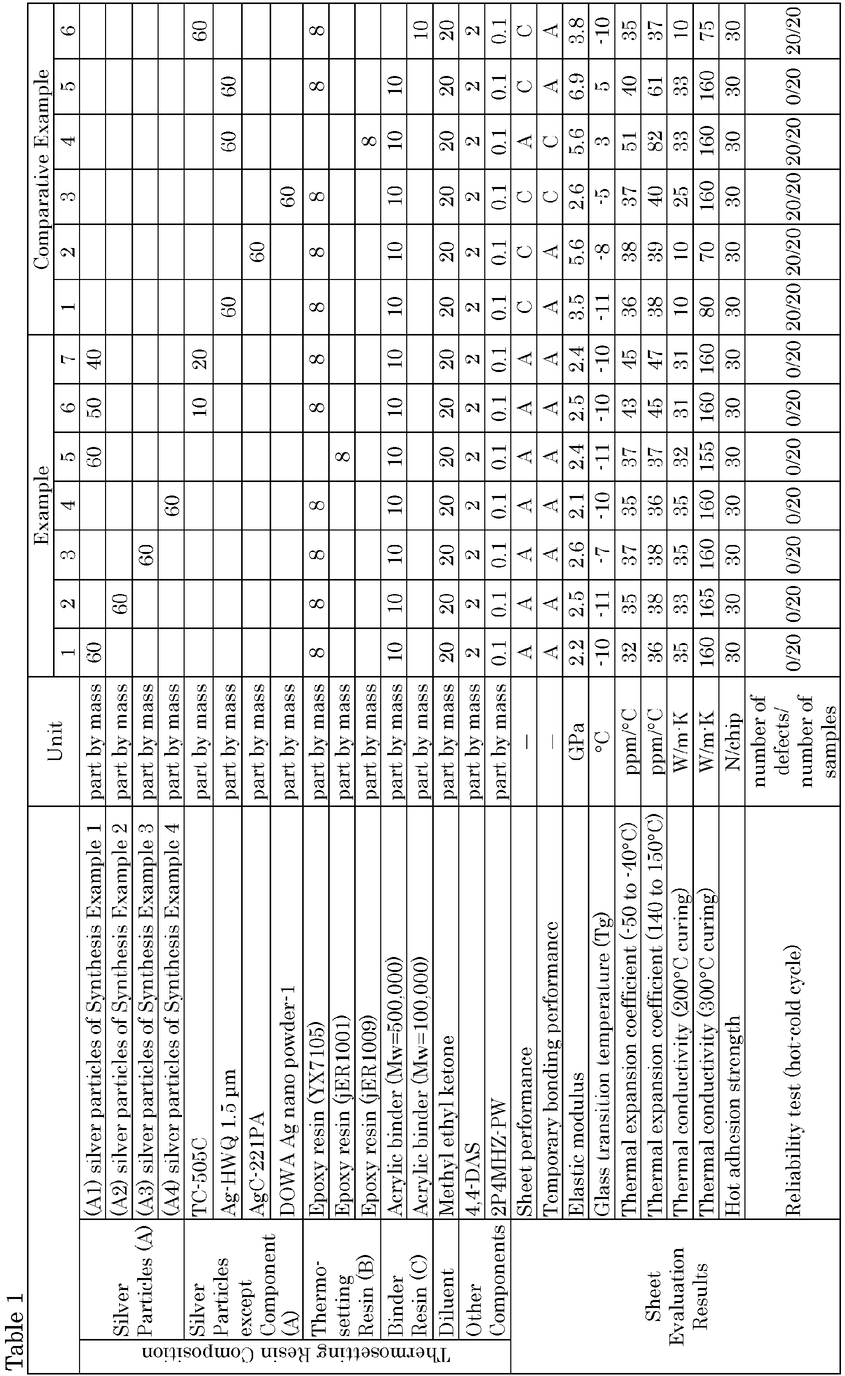

In Examples 1 to 7 using a thermoconductive adhesive sheet that was sheet-like formed of a resin composition containing silver particles (A), semiconductor devices all excellent in temporary bonding performance and sheet performance, having a high thermal conductivity even under low-temperature sintering conditions at 200°C or lower, and excellent in reliability can be produced.

## Claims

1. A thermoconductive adhesive sheet which is sheet-like formed of a resin composition comprising (A) silver particles, (B) a thermosetting resin, and (C) a binder resin, wherein:
the silver particles (A) are secondary particles formed through aggregation of particles that contain primary particles having an average particle size of 10 to 100 nm, determined as described in the description, and
the silver particles (A) have an average particle size of 0.5 to 5.0 pm, determined as described in the description.

2. The thermoconductive adhesive sheet according to claim 1, wherein the silver particles (A) have a positive thermal expansion coefficient between 150°C and 300°C, determined as described in the description.

3. The thermoconductive adhesive sheet according to claim 1 or 2, wherein the silver particles (A) have a tap density of 4.0 to 7.0 g/cm³, determined as described in the description.

4. The thermoconductive adhesive sheet according to any of claims 1 to 3, wherein the silver particles (A) have a specific surface area, as measured according to the BET method, of 0.5 to 1.5 m²/g.

5. The thermoconductive adhesive sheet according to any of claims 1 to 4, wherein the silver particles (A) are hollow particles.

6. The thermoconductive adhesive sheet according to any of claims 1 to 5, wherein the thermosetting resin (B) is liquid or is a solid material having a softening point of 70°C or lower.

7. The thermoconductive adhesive sheet according to any of claims 1 to 6, wherein the thermosetting resin (B) is at least one selected from the group consisting of an epoxy resin, a cyanate resin, and a maleimide resin.

8. The thermoconductive adhesive sheet according to any of claims 1 to 7, wherein the binder resin (C) has a weight-average molecular weight, determined by converting the chromatogram measured through gel permeation chromatography into a standard polystyrene-equivalent molecular weight, of 200,000 to 1,000,000 and a glass transition temperature, determined according to JIS K7121:2012, of -40°C to 0°C.

9. The thermoconductive adhesive sheet according to any of claims 1 to 8, wherein the total content of the content of the thermosetting resin (B) and the content of the binder resin (C) is 5 to 30% by mass relative to the total amount of the resin composition, and the content of the silver particles (A) is 30 to 95% by mass.

10. The thermoconductive adhesive sheet according to any of claims 1 to 9, wherein the resin composition has, after cured, an elastic modulus, determined as described in paragraph [0089] of the description, of 3 GPa or less, a glass transition temperature (Tg), determined as described in paragraph [0090] of the description, of 0°C or lower, and a thermal expansion coefficient, determined as described in the description, of 50 ppm/°C or less at -50 to -40°C and at 140°C to 150°C.

11. The thermoconductive adhesive sheet according to any of claims 1 to 10, wherein a cured product of the resin composition cured at 200°C or lower has a thermal conductivity of 30 W/m K or more, determined as described in the description.

12. A semiconductor device having a supporting member, a cured product of the thermoconductive adhesive sheet of any of claims 1 to 11 provided on the supporting member, and a semiconductor element bonded onto the supporting member via the cured product of the thermoconductive adhesive sheet.

13. A production method for the thermoconductive adhesive sheet comprising:
a step of preparing a resin composition by mixing (A) a silver particles which are secondary particles formed through aggregation of particles that contain primary particles having an average particle size of 10 to 100 nm, determined as described in paragraph [0013] of the description, (B) a thermosetting resin, and (C) a binder resin, the silver particles (A) having an average particle size of 0.5 to 5.0 pm, determined as described in the description;
a step of forming the resin composition obtained in the above-described step into a sheet.

14. The production method for the thermoconductive adhesive sheet according to claim 13,
wherein (A) the silver particles are obtained by a method for producing silver particles comprising a step of adding an aqueous ammonia to an aqueous solution containing a silver compound to give a silver ammine complex solution, and a step of reducing the silver ammine complex in the silver ammine complex solution prepared in the previous step with a reducing compound to give a slurry containing silver particles.

## Patentansprüche

1. Wärmeleitende Klebefolie, die folienartig aus einer Harzzusammensetzung gebildet ist, die (A) Silberpartikel, (B) ein wärmehärtendes Harz und (C) ein Bindemittelharz aufweist, wobei:
die Silberpartikel (A) Sekundärpartikel sind, die durch Aggregation von Partikeln gebildet werden, die Primärpartikel enthalten, die eine durchschnittliche Partikelgröße von 10 bis 100 nm haben, ermittelt wie in der Beschreibung beschrieben, und
die Silberpartikel (A) eine durchschnittliche Partikelgröße von 0,5 bis 5,0 µm haben, ermittelt wie in der Beschreibung beschrieben.

2. Wärmeleitende Klebefolie gemäß Anspruch 1, wobei die Silberpartikel (A) einen positiven Wärmeausdehnungskoeffizienten zwischen 150 °C und 300 °C haben, ermittelt wie in der Beschreibung beschrieben.

3. Wärmeleitende Klebefolie gemäß Anspruch 1 oder 2, wobei die Silberpartikel (A) eine Klopfdichte von 4,0 bis 7,0 g/cm³ haben, ermittelt wie in der Beschreibung beschrieben.

4. Wärmeleitende Klebefolie gemäß irgendeinem der Ansprüche 1 bis 3, wobei die Silberpartikel (A) eine spezifische Oberfläche, gemessen nach dem BET-Verfahren, von 0,5 bis 1,5 m²/g haben.

5. Wärmeleitende Klebefolie gemäß irgendeinem der Ansprüche 1 bis 4, wobei die Silberpartikel (A) Hohlpartikel sind.

6. Wärmeleitende Klebefolie gemäß irgendeinem der Ansprüche 1 bis 5, wobei das wärmehärtende Harz (B) flüssig ist oder ein festes Material ist, das einen Erweichungspunkt von 70 °C oder weniger hat.

7. Wärmeleitende Klebefolie gemäß irgendeinem der Ansprüche 1 bis 6, wobei das wärmehärtende Harz (B) mindestens eines ist, das aus der Gruppe ausgewählt ist, die aus einem Epoxidharz, einem Cyanatharz und einem Maleimidharz besteht.

8. Wärmeleitende Klebefolie gemäß irgendeinem der Ansprüche 1 bis 7, wobei das Bindemittelharz (C) ein gewichtsmittleres Molekulargewicht, ermittelt durch Konvertieren des mittels Gelpermeationschromatographie gemessenen Chromatogramms in ein Standardpolystyrol-Äquivalentmolekulargewicht, von 200 000 bis 1 000 000 und eine Glasübergangstemperatur, ermittelt gemäß JIS K7121:2012, von -40 °C bis 0 °C hat.

9. Wärmeleitende Klebefolie gemäß irgendeinem der Ansprüche 1 bis 8, wobei der Gesamtgehalt des Gehalts des wärmehärtenden Harzes (B) und des Gehalts des Bindemittelharzes (C) 5 bis 30 Masse-% bezogen auf die Gesamtmenge der Harzzusammensetzung beträgt und der Gehalt der Silberpartikel (A) 30 bis 95 Masse-% beträgt.

10. Wärmeleitende Klebefolie gemäß irgendeinem der Ansprüche 1 bis 9, wobei die Harzzusammensetzung nach dem Aushärten einen Elastizitätsmodul, ermittelt wie in Absatz [0089] der Beschreibung beschrieben, von 3 GPa oder weniger, eine Glasübergangstemperatur (Tg), ermittelt wie in Absatz [0090] der Beschreibung beschrieben, von 0°C oder weniger und einen Wärmeausdehnungskoeffizienten, ermittelt wie in der Beschreibung beschrieben, von 50 ppm/°C oder weniger bei -50 bis -40 °C und bei 140 °C bis 150 °C hat.

11. Wärmeleitende Klebefolie gemäß irgendeinem der Ansprüche 1 bis 10, wobei ein gehärtetes Produkt der Harzzusammensetzung, das bei 200 °C oder weniger gehärtet wird, eine Wärmeleitfähigkeit von 30 W/m-K oder mehr hat, ermittelt wie in der Beschreibung beschrieben.

12. Halbleitervorrichtung, aufweisend ein Trägerelement, ein gehärtetes Produkt der wärmeleitenden Klebefolie gemäß irgendeinem der Ansprüche 1 bis 11, bereitgestellt auf dem Trägerelement, und ein Halbleiterelement, das über das gehärtete Produkt der wärmeleitenden Klebefolie auf das Trägerelement gebondet ist.

13. Herstellungsverfahren für die wärmeleitende Klebefolie, aufweisend:
einen Schritt des Herstellens einer Harzzusammensetzung durch Mischen von (A) Silberpartikeln, die Sekundärpartikel sind, die durch Aggregation von Partikeln gebildet werden, die Primärpartikel enthalten, die eine durchschnittliche Partikelgröße von 10 bis 100 nm haben, ermittelt wie in Absatz [0013] der Beschreibung beschrieben, (B) einem wärmehärtenden Harz und (C) einem Bindemittelharz, wobei die Silberpartikel (A) eine durchschnittliche Partikelgröße von 0,5 bis 5,0 µm haben, ermittelt wie in der Beschreibung beschrieben;
einen Schritt des Formens der in dem oben beschriebenen Schritt erhaltenen Harzzusammensetzung zu einer Folie.

14. Herstellungsverfahren für die wärmeleitende Klebefolie gemäß Anspruch 13,
wobei (A) die Silberpartikel durch ein Verfahren zum Herstellen von Silberpartikeln erhalten werden, aufweisend einen Schritt des Zugebens eines wässrigen Ammoniaks zu einer wässrigen Lösung, die eine Silberverbindung enthält, um eine Silberamin-Komplexlösung zu erhalten, und einen Schritt des Reduzierens des Silberamin-Komplexes in der im vorherigen Schritt hergestellten Silberamin-Komplexlösung mit einer reduzierenden Verbindung, um eine Aufschlämmung zu erhalten, die Silberpartikel enthält.

## Revendications

1. Feuille adhésive thermoconductrice en forme de feuille formée d'une composition de résine comprenant (A) des particules d'argent, (B) une résine thermodurcissable, et (C) une résine liante, dans laquelle :
les particules d'argent (A) sont des particules secondaires formées par agrégation de particules contenant des particules primaires ayant une taille moyenne de particule de 10 à 100 nm, déterminée comme décrit dans la description, et
les particules d'argent (A) ont une taille moyenne de particule de 0,5 à 5,0 µm, déterminée comme décrit dans la description.

2. Feuille adhésive thermoconductrice selon la revendication 1, dans laquelle les particules d'argent (A) ont un coefficient de dilatation thermique positif compris entre 150 °C et 300 °C, déterminé comme décrit dans la description.

3. Feuille adhésive thermoconductrice selon la revendication 1 ou 2, dans laquelle les particules d'argent (A) ont une densité de claquage de 4,0 à 7,0 g/cm³, déterminée comme décrit dans la description.

4. Feuille adhésive thermoconductrice selon l'une quelconque des revendications 1 à 3, dans laquelle les particules d'argent (A) ont une surface spécifique, mesurée selon le procédé BET, de 0,5 à 1,5 m²/g.

5. Feuille adhésive thermoconductrice selon l'une quelconque des revendications 1 à 4, dans laquelle les particules d'argent (A) sont des particules creuses.

6. Feuille adhésive thermoconductrice selon l'une quelconque des revendications 1 à 5, dans laquelle la résine thermodurcissable (B) est liquide ou est un matériau solide ayant un point de ramollissement de 70 °C ou moins.

7. Feuille adhésive thermoconductrice selon l'une quelconque des revendications 1 à 6, dans laquelle la résine thermodurcissable (B) est au moins une choisie dans le groupe constitué d'une résine époxy, d'une résine cyanate et d'une résine maléimide.

8. Feuille adhésive thermoconductrice selon l'une quelconque des revendications 1 à 7, dans laquelle la résine liante (C) a un poids moléculaire moyen en poids, déterminé en convertissant le chromatogramme mesuré par chromatographie par perméation de gel en un poids moléculaire standard équivalent au polystyrène, de 200 000 à 1 000 000 et une température de transition vitreuse, déterminée selon JIS K7121:2012, de -40 °C à 0 °C.

9. Feuille adhésive thermoconductrice selon l'une quelconque des revendications 1 à 8, dans laquelle la teneur totale de la teneur en résine thermodurcissable (B) et de la teneur en résine liante (C) est de 5 à 30 % en masse par rapport à la quantité totale de la composition de résine, et la teneur en particules d'argent (A) est de 30 à 95 % en masse.

10. Feuille adhésive thermoconductrice selon l'une quelconque des revendications 1 à 9, dans laquelle la composition de résine présente, après durcissement, un module d'élasticité, déterminé comme décrit au paragraphe [0089] de la description, de 3 GPa ou moins, une température de transition vitreuse (Tg), déterminée comme décrit au paragraphe [0090] de la description, de 0 °C ou moins, et un coefficient de dilatation thermique, déterminé comme décrit dans la description, de 50 ppm/°C ou moins à -50 à -40 °C et à 140 °C à 150 °C.

11. Feuille adhésive thermoconductrice selon l'une quelconque des revendications 1 à 10, dans laquelle un produit durci de la composition de résine durci à 200 °C ou moins présente une conductivité thermique de 30 W/m-K ou plus, déterminée comme décrit dans la description.

12. Dispositif semi-conducteur comportant un élément de support, un produit durci de la feuille adhésive thermoconductrice selon l'une quelconque des revendications 1 à 11 disposé sur l'élément de support, et un élément semi-conducteur collé sur l'élément de support via le produit durci de la feuille adhésive thermoconductrice.

13. Procédé de production pour la feuille adhésive thermoconductrice, comprenant :
une étape de préparation d'une composition de résine en mélangeant (A) des particules d'argent qui sont des particules secondaires formées par agrégation de particules qui contiennent des particules primaires ayant une taille moyenne de particule de 10 à 100 nm, déterminée comme décrit au paragraphe [0013] de la description, (B) une résine thermodurcissable, et (C) une résine liante, les particules d'argent (A) ayant une taille moyenne de particule de 0,5 à 5,0 µm, déterminée comme décrit dans la description ;
une étape de formation de la composition de résine obtenue à l'étape décrite ci-dessus en une feuille.

14. Procédé de fabrication pour la feuille adhésive thermoconductrice selon la revendication 13,
dans lequel (A) les particules d'argent sont obtenues par un procédé de production de particules d'argent comprenant une étape d'ajout d'un ammoniac aqueux à une solution aqueuse contenant un composé d'argent pour donner une solution de complexe d'amine d'argent, et une étape de réduction du complexe d'amine d'argent dans la solution de complexe d'amine d'argent préparée à l'étape précédente avec un composé réducteur pour donner une suspension contenant des particules d'argent.
